# NEUE EUROPÄISCHE PATENTSCHRIFT

(11) **EP 1 150 792 B2**
(45) Veröffentlichungstag und Bekanntmachung des Hinweises auf die Entscheidung über den Einspruch: **07.06.2006**
(45) Hinweis auf die Patenterteilung: 07.08.2002
(21) Anmeldenummer: 00901834.2
(22) Anmeldetag: 07.02.2000
(51) Int. Cl.: B23B 51/02, B23P 15/28

(54) **VERFAHREN ZUM HERSTELLEN EINES ZERSPANUNGSWERKZEUGS SOWIE ZERSPANUNGSWERKZEUG**
METHOD FOR PRODUCING A CUTTING TOOL AND A CUTTING TOOL
PROCEDE DE PRODUCTION D'UN OUTIL D'ENLEVEMENT DE COPEAUX, ET OUTIL D'ENLEVEMENT DE COPEAUX

(30) Priorität: 11.02.1999 DE 19905735
(43) Veröffentlichungstag der Anmeldung: 07.11.2001
(73) Patentinhaber: KENNAMETAL INC., Latrobe, PA 15650-0231 (US)
(72) Erfinder: BORSCHERT, Bernhard, Walter, D-90408 Nürnberg (DE); MÜHLFRIEDEL, Dieter, Hermann, D-91320 Ebermannstadt (DE); WENDT, Karl-Heinz, D-91320 Ebermannstadt (DE)
(74) Vertreter: Sties, Jochen
(86) Internationale Anmeldenummer: PCT/IB2000/000122
(87) Internationale Veröffentlichungsnummer: WO 2000/047357

(56) Entgegenhaltungen:
- EP-A- 0 812 650
- WO-A-96/30148
- US-A- 4 643 620
- US-A- 5 762 538

## Beschreibung

Die Erfindung betrifft ein Verfahren zum Herstellen eines Zerspanungswerkzeugs, das eine Spitze, einen Schaft und einen Spannutbereich aufweist, in welchem Spankammern gebildet sind, wobei das Zerspanungswerkzeug im wesentlichen vollständig mit einem Hartstoff beschichtet wird. Die Erfindung betrifft ferner ein Zerspanungswerkzeug, das durch ein solches Verfahren hergestellt werden kann.

Dieses Zerspanungswerkzeug kann beispielsweise ein Fräser, eine Reibahle, ein Bohrer oder ein Gewindebohrer sein. Nachfolgend wird auf einen Bohrer, insbesondere einen Vollhartmetallbohrer, Bezug genommen.

Der Bohrer wird mit dem Hartstoff beschichtet, um die Standzeiten zu erhöhen. Zu diesem Zweck wird die Beschichtung auf den gesamten Schneidenbereich des Bohrers aufgebracht, also auf die Bohrspitze sowie den Spankammerbereich des Werkzeugs. Die Hartstoffbeschichtung führt dann zur gewünschten Verschleißfestigkeit des Bohrers (Siehe z.B. US-A-4 643 620).

Neben der Verschleißfestigkeit des Bohrers ist für die Leistungsfähigkeit auch relevant, wie gut die durch die Zerspanarbeit an der Bohrspitze gebildeten Späne durch die Spankammern abtransportiert werden können. Für einen guten Spanfluß müssen die Spankammern möglichst glatt sein. Diese Voraussetzung wird erfüllt, wenn die Hartstoffbeschichtung auf die geschliffene Oberfläche des Bohrers aufgebracht wird. In diesem Fall weist auch die Beschichlung eine sehr geringe Rauheit auf, so daß der gewünschte Spanfluß erhalten wird.

Es hat sich jedoch herausgestellt, daß die Hartstoffbeschichtung auf dem Bohrer nicht immer im gewünschten Maße haftet, wenn die geschliffene Oberfläche des Bohrers unmittelbar beschichtet wird. Die Haftung konnte jedoch deutlich verbessert werden, indem die geschliffene Oberfläche des Bohrers vor dem Beschichten mikrogestrahlt wurde. Durch das Mikrostrahlen kommt es zu einer geringfügigen plastischen Verformung der Randzone des Bohrers, wodurch die Druckeigenspannungen erhöht werden. Gleichzeitig bewirkt das Mikrostrahlen eine deutliche Verringerung des Eigenspannungsgradienten in der Randzone des derart bearbeiteten Bohrers. Ferner kommt es zu einer starken Veränderung der Mikrolopographie. Diese Veränderung sorgt dafür, daß eine nachfolgend aufgebrachte Hartstoffbeschichtung besser an der Oberfläche des Bohrers haftet. Dies führt dazu, daß die Hartstoffbeschichtung ein verbessertes Verschleißverhalten zeigt (siehe den Artikel "Einfluß der Substratbearbeitung auf das Verschleißverhalten von beschichteten Hartmetallwerkzeugen" von Prof. Dr.-Ing. H.K. Tönshoff, Dipl.-Ing. A. Mohlfeld und Dipl.-Phys. H. Seegers, Institut für Fertigungstechnik und Spanende Werkzeugmaschinen der Universität Hannover).

Nachteilig ist aber, daß die mikrogestrahlte Oberfläche eine größere Rauheit hat, so daß auch die beschichtete Oberfläche eine größere Rauheit hat als bei einem Bohrer, bei dem die Hartstoffbeschichtung unmittelbar auf die geschliffene Oberfläche aufgebracht wird. Es ergibt sich somit ein höherer Reibungskoeffizient, der einen schlechteren Spanfluß in den Spankammern zur Folge hat.

Die Erfindung beseitigt diesen Nachteil, indem vor dem Beschichten des Zerspanungswerkzeugs mit dem Hartstoff, beispielsweise des Bohrers, lediglich die Spitze mikrogestrahft wird. Auf diese Weise läßt sich ein gutes Haftvermögen der Beschichtung in den Bereichen, in denen es erforderlich ist, mit einer glatten Oberfläche des Werkzeugs und somit einem guten Spanfluß in den Bereichen kombinieren, in denen dies erforderlich ist. Die gesamte Zerspanarbeit wird im Bereich der Spitze geleistet, so daß hier ein gutes Haftvermögen der Beschichtung von größter Bedeutung ist. Der Spanfluß ist im Bereich der Spitze von nachgeordneter Bedeutung. Im Bereich der Spankammern sind die auftretenden Belastungen dagegen sehr viel geringer als an der Spitze, so daß hier das Haftvermögen der Hartstoffbeschichtung auf der nicht nachbehandelten Oberfläche ausreichend ist. Im Bereich der Spankammern ist dagegen ein niedriger Reibungskoeffizient von besonderer Bedeutung, der dadurch gewährleistet ist, daß die Beschichtung auf die nicht mikrogestrahlte und somit glatte Oberfläche des Werkzeugs aufgebracht wird, so daß sich der gewünschte niedrige Reibungskoeffizient ergibt.

Vorteilhafte Ausgestaltungen der Erfindung ergeben sich aus den Unteransprüchen.

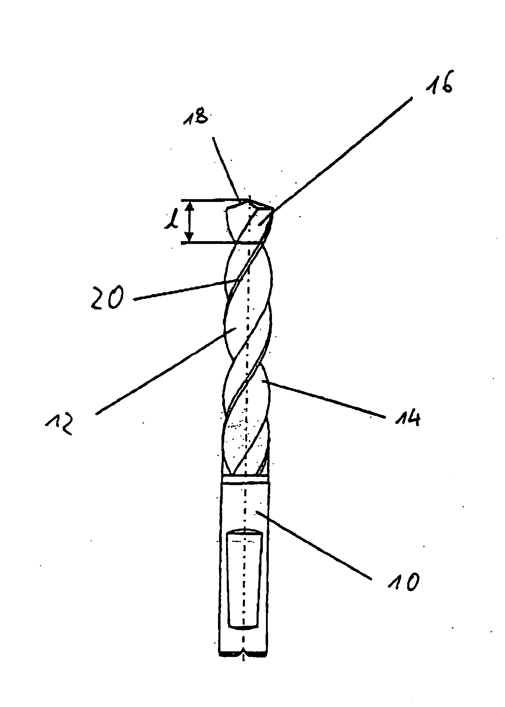

Die Erfindung wird nachfolgend unter Bezugnahme auf die beigefügte einzige Figur beschrieben. In dieser ist ein erfindungsgemäßes Zerspanungswerkzeug gezeigt.

Als ein Beispiel für ein erfindungsgemäßes Zerspanungswerkzeug wird nachfolgend ein Bohrer beschrieben. Das erfindungsgemäße Verfahren und der erfindungsgemäße Aufbau des Werkzeugs können aber auf beliebige andere Zerspanungswerkzeuge angewendet werden, beispielsweise Fräser, Reibahlen, Gewindebohrer, etc.

Der Bohrer weist einen Schaft 10 sowie einen Spannutbereich auf, in welchem zwei Spankammern 12, 14 ausgebildet sind. Am vorderen Ende ist eine Bohrspitze 16 gebildet, die den Bereich der Hauptschneide 18 des Bohrers sowie ausgehend von der Querschneide des Bohrers einen Bereich mit einer Länge 1 von etwa dem Zweifachen des Durchmessers des Bohrers erfaßt.

Der Bohrer ist ein Vollhartmetallbohrer. Er weist als Substrat also ein Bindemetall, beispielsweise Kobalt, Nickel und/oder Eisen, mit darin gebundenem Hartstoff auf, beispielsweise Wolfram-, Titan-, Tantalcarbid und/oder Bornitrid.

Der Bohrer hat eine geschliffene Oberfläche im Bereich der Spankammer 12, 14 sowie im Bereich der Bohrspitze 16. Zunächst wird dieser Bohrer gereinigt und getrocknet. Anschließend wird die Bohrspitze 16 mikrogestrahlt. Hierzu wird vorzugsweise als Material Korund 500 (Körnung dₖ zwischen 5 und 50 µm) bei einem Strahldruck von 0,5 bis 5 bar verwendet. Die Bohrspitze wird so lange gestrahlt, bis eine gleichmäßig matte Oberfläche erzielt ist. Anschließend wird der Bohrer in aus dem Stand der Technik bekannter Weise gereinigt.

Abschließend wird mindestens der Schneidenbereich des Bohrers, also der Bereich der Spankammer 12, 14 und die Bohrspitze 16, mit einer PVD-Hartstoffbeschichtung versehen. Grundsätzlich kann jeder Hartstoff verwendet werden, der zum einen mit PVD-Verfahren aufgebracht werden kann und zum anderen mit dem als Substrat verwendeten Hartmetall kompatibel ist. Ein geeignetes Material für die HartstoffBeschichtung ist beispielsweise Titan-Aluminium-Nitrid, Titannitrid, Borcarbonitrid oder Titancarbonitrid.

Das Mikrostrahlen erhöht die Oberflächenrauhigkeit. Durch Messungen an der Führungsfase 20 des Bohrers wurde in den nicht mikrogestrahlten Bereichen eine Rauheit R_{Z} gemäß DIN 4768 und DIN 4768 T1 zwischen 0,7 und 0,8 µm ermittelt. Im Bereich der mikrogestrahlten Bohrspitze 16 ergab sich an der Führungsfase 20 eine Rauheit R_{Z} zwischen 0,9 und 1,0 µm. Diese Werte gelten sowohl vor als auch nach dem Beschichten des Bohrers mit der PVD-Hartstoffbeschichtung.

## Patentansprüche

1. Verfahren zum Herstellen eines Zerspanungswerkzeugs, das eine Spitze (16), einen Schaft (10) sowie einen Spannutbereich aufweist, in welchem Spankammern (12, 14) gebildet sind, wobei das Zerspanungswerkzeug im wesentlichen vollständig mit einem Hartstoff beschichtet wird, **dadurch gekennzeichnet, daß** vor dem Beschichten des Zerspanungswerkzeugs mit dem Hartstoff lediglich die Spitze (16) mikrogestrahlt wird.

2. Verfahren nach Anspruch 1, **dadurch gekennzeichnet, daß** der Schritt des Mikrostrahlens der Spitze (16) einen Bereich von etwa dem Zweifachen des Durchmessers des Zerspanungswerkzeugs, ausgehend von dem Vorderende des Zerspanungswerkzeugs, erfaßt.

3. Verfahren nach einem der Ansprüche 1 und 2, **dadurch gekennzeichnet, daß** die Beschichtung des Zerspanungswerkzeugs als PVD-Beschichtung vorgenommen wird.

4. Verfahren nach einem der Ansprüche 1 bis 3, **dadurch gekennzeichnet, daß** als Strahlmedium für das Mikrostrahlen Al₂O₃ mit einer Körnung dₖ zwischen etwa 5 µm und 50 µm verwendet wird.

5. Zerspanungswerkzeug, das eine Spitze (16), einen Schaft (10) sowie einen Spannutbereich aufweist, in welchem Spankammern (12, 14) gebildet sind, wobei nur die Spitze (16) mikrogestrahlt ist und das Zerspanungswerkzeug im wesentlichen vollständig mit einem Hartstoff beschichtet ist.

6. Zerspanungswerkzeug nach Anspruch 5, **dadurch gekennzeichnet, daß** es ein Vollhartmetallwerkzeug ist.

7. Zerspanungswerkzeug nach Anspruch 6, **dadurch gekennzeichnet, daß** als Bindemetall Kobalt, Nikkel und/oder Eisen und als darin gebundener Hartstoff Wolfram-, Titan-, Tantalcarbid und/oder Bornitrid verwendet wird.

8. Zerspanungswerkzeug nach einem der Ansprüche 5 bis 7, **dadurch gekennzeichnet, daß** es in den nicht mikrogestrahlten Bereichen eine um mindestens R_{Z} 0,2 µm feinere Oberfläche aufweist als in mikrogestrahlten Bereichen.

9. Zerspanungswerkzeug nach Anspruch 8, **dadurch gekennzeichnet, daß** es in den nicht mikrogeslrahlten Bereichen eine Rauheit R_{Z} zwischen 0,7 und 0,8 µm und in den mikrogestrahlten Bereichen eine Rauheit R_{Z} zwischen 0,9 und 1,0 µm aufweist.

10. Zerspanungswerkzeug nach einem der Ansprüche 5 bis 9, **dadurch gekennzeichnet, daß** es ein Bohrer ist.

11. Zerspanungswerkzeug nach einem der Ansprüche 5 bis 9, **dadurch gekennzeichnet, daß** es ein Gewindebohrer ist.

12. Zerspanungswerkzeug nach einem der Ansprüche 5 bis 9, **dadurch gekennzeichnet, daß** es ein Fräser ist.

13. Zerspanungswerkzeug nach einem der Ansprüche 5 bis 9, **dadurch gekennzeichnet, daß** es eine Reibahle ist.

14. Zerspanungswerkzeug nach einem der Ansprüche 5 bis 13, **dadurch gekennzeichnet, daß** der als Beschichtung verwendete Hartstoff Borcarbonitrid, Titancarbonitrid, Titan-Aluminium-Nitrid und/oder Titannitrid ist.

## Claims

1. A method of making a cutting tool comprising a tip (16), a shank (10) and a flute area having chip spaces (12, 14) formed therein, the cutting tool being substantially completely coated with a hard material,
**characterized by** microblasting merely the tip (16) before coating the cutting tool with the hard material.

2. The method as claimed in claim 1, **characterized in that** the step of microblasting the tip (16) covers an area of approximately twice the diameter of the cutting tool, starting from the front end of the cutting tool.

3. The method as claimed in either of claims 1 and 2, **characterized in that** the coating of the cutting tool is performed as a PVD coating.

4. The method as claimed in any of claims 1 to 3, **characterized in that** Al₂O₃ having an average grain size of between about 5µm and 50µm is used as the blasting medium for the microblasting.

5. A cutting tool comprising a tip (16), a shank (10) and a flute area having chip spaces (12, 14) formed therein, only the tip (16) being microblasted and the cutting tool being substantially completely coated with a hard material.

6. The cutting tool as claimed in claim 5, **characterized in that** it is a solid carbide tool.

7. The cutting tool as claimed in claim 6, **characterized in that** cobalt, nickel and/or iron is used as binding metal and tungsten carbide, titanium carbide, tantalum carbide and/or boron nitride is used as hard material bound therein.

8. The cutting tool as claimed in any of claims 5 to 7, **characterized in that** its surface in the non-microblasted areas is by at least R_{z} 0.2 µm finer than in microblasted areas.

9. The cutting tool as claimed in claim 8, **characterized in that** it has a roughness R_{z} of between 0.7 and 0.8 µm in the non-microblasted areas and a roughness R_{z} of between 0.9 and 1.0 µm in the microblasted areas.

10. The cutting tool as claimed in any of claims 5 to 9, **characterized in that** it is a drill.

11. The cutting tool as claimed in any of claims 5 to 9, **characterized in that** it is a tapping drill.

12. The cutting tool as claimed in any of claims 5 to 9, **characterized in that** it is a milling cutter.

13. The cutting tool as claimed in any of claims 5 to 9, **characterized in that** it is a reamer.

14. The cutting tool as claimed in any of claims 5 to 13, **characterized in that** the hard material used as coating is boron carbonitride, titanium carbonitride, titanium aluminium nitride and/or titanium nitride.

## Revendications

1. Procédé de fabrication d'un outil à enlèvement de copeaux qui présente une pointe (16), une tige (10) ainsi qu'une zone de rainure à copeaux dans laquelle sont formées des chambres à copeaux (12, 14), l'outil à enlèvement de copeaux étant revêtu sensiblement totalement par une matière dure,
**caractérisé en ce qu'**avant de revêtir l'outil à enlèvement de copeaux avec la matière dure, seule la pointe (16) est micro-grenaillée.

2. Procédé selon la revendication 1, **caractérisé en ce que** l'étape de micro-grenaillage de la pointe (16) couvre une zone d'environ le double du diamètre de l'outil à enlèvement de copeaux, en partant de l'extrémité antérieure de l'outil à enlèvement de copeaux.

3. Procédé selon l'une des revendications 1 et 2, **caractérisé en ce que** le revêtement de l'outil à enlèvement de copeaux est effectuée sous forme de revêtement par dépôt en phase gazeuse par procédé physique.

4. Procédé selon l'une des revendications 1 et 3, **caractérisé en ce qu'**on utilise comme moyen de grenaillage pour le micro-grenaillage Al₂O₃ avec une grosseur de grain dₖ entre 5 µm et 50 µm

5. Outil à enlèvement de copeaux qui présente une pointe (16), une tige (10) ainsi qu'une zone de rainure à copeaux dans laquelle sont formées des chambres à copeaux (12, 14), seule la pointe (16) étant micro-grenaillée et l'outil à enlèvement de copeaux étant sensiblement totalement revêtu par une matière dure.

6. Outil à enlèvement de copeaux selon la revendication 5, **caractérisé en ce qu'**il s'agit d'un outil en métal entièrement dur .

7. Outil à enlèvement de copeaux selon la revendication 6, **caractérisé en ce qu'**on utilise comme métal liant du cobalt, du nickel et/ou du fer et comme matière dure du carbure de tungstène, du carbure de titane, du carbure de tantale et/ou du nitrure de bore.

8. Outil à enlèvement de copeaux selon l'une des revendications 5 à 7, **caractérisé en ce que** dans les zones non micro-grenaillées, il présente une surface plus fine d'au moins R_{z} 0,2 µm que dans les zones micro-grenaillées.

9. Outil à enlèvement de copeaux selon la revendication 8, **caractérisé en ce que** dans les zones non micro-grenaillées, il présente une rugosité R_{Z} entre 0,7 et 0,8 µm et dans les régions micro-grenaillées, il présente une rugosité R_{Z} entre 0,9 et 1,0 µm.

10. Outil à enlèvement de copeaux selon l'une des revendications 5 à 9, **caractérisé en ce qu'**il est un foret.

11. Outil à enlèvement de copeaux selon l'une des revendications 5 à 9, **caractérisé en ce qu'**il est un taraud.

12. Outil à enlèvement de copeaux selon l'une des revendications 5 à 9, **caractérisé en ce qu'**il est un foret à fraiser.

13. Outil à enlèvement de copeaux selon l'une des revendications 5 à 9, **caractérisé en ce qu'**il est un alésoir.

14. Outil à enlèvement de copeaux selon l'une des revendications 5 à 13, **caractérisé en ce que** la matière dure utilisée comme revêtement est du nitrure de bore, du carbonitrure de bore, du carbonitrure de titane, du nitrure d'aluminium-titane et/ou du nitrure de titane
